# EUROPÄISCHE PATENTSCHRIFT

(11) **EP 2 254 170 B1**
(45) Veröffentlichungstag und Bekanntmachung des Hinweises auf die Patenterteilung: **08.01.2014**
(21) Anmeldenummer: 10004929.5
(22) Anmeldetag: 10.05.2010
(51) Int. Cl.: H02N 2/06, H01L 41/04, H02M 3/157, H02M 3/158

(54) **Schaltungsanordnung zur Ansteuerung einer kapazitiven Last**
Switching assembly for actuating a capacitive load
Circuit de commande d'une charge capacitive

(30) Priorität: 20.05.2009 DE 202009007299 U
(43) Veröffentlichungstag der Anmeldung: 24.11.2010
(73) Patentinhaber: Bürkert Werke GmbH, 74653 Ingelfingen (DE)
(72) Erfinder: Dreher, Tobias, 01069 Dresden (DE); Fuchs, Maik, 01277 Dresden (DE)
(74) Vertreter: Prinz & Partner

(56) Entgegenhaltungen:
- EP-A2- 1 763 125
- US-A1- 2007 278 968

## Beschreibung

Die Erfindung betrifft ein Verfahren und eine Schaltungsanordnung zum Ansteuern einer kapazitiven Last, insbesondere eines piezoelektrischen Aktorelements.

Es ist bekannt, kapazitive Lasten aus einer Gleichspannungsquelle mittels Aufwärts- bzw. Abwärtswandler anzusteuern. Derartige Wandler erzeugen aus einer Spannung am Eingang des Wandlers durch hochfrequentes Ansteuern eines Schaltelementes eine höhere bzw. niedrigere Spannung am Ausgang. Die Spannung am Ausgang ist abhängig von der Frequenz und dem Tastverhältnis des Schaltsignals. Eine Auswahl von Schaltwandlertopologien findet sich z.B. in Tietze, Schenk: Halbleiter-Schaltungstechnik. 11. Aufl. Berlin: Springer, 1999.

Piezoelektrische Aktoren sind elektromechanische Wandler, die elektrische Ladung in mechanische Dehnung umsetzen. Piezoaktoren stellen in elektrischen Schaltkreisen annähernd eine kapazitive Last dar. Damit benötigen sie fast keine elektrische Leistung zum Halten einer Position. Weiterhin ist beim Abschalten eine Rückgewinnung der im Aktor gespeicherten Ladung möglich. Der Einsatz der Piezotechnologie ermöglicht so eine deutliche Leistungsreduzierung gegenüber herkömmlichen Aktorsystemen. Je nach Bauart und mechanischer Last erreichen Piezoaktoren ihre maximale Ausdehnung innerhalb weniger Mikrosekunden. Voraussetzung dafür ist eine entsprechend dynamisch ausgelegte Ansteuerung, die in der Lage ist, die Kapazität innerhalb dieser Zeit vollständig zu laden bzw. zu entladen. Zur Aussteuerung der Piezoaktoren sind allerdings relativ hohe Spannungen nötig, die je nach Aktorbauform über 100 V liegen. Desweiteren besitzen Piezoaktoren nichtlineare Eigenschaften. So zeigen sie bei Spannungsregelung ein stark hysteresebehaftetes Auslenkungsverhalten. Bei Regelung der Aktorladung wird die Hysterese verringert und die Laststeifigkeit erhöht. Jedoch ist das Halten (Regelung) der Aktorladung aufgrund von Leckströmen extrem aufwendig.

Für die Regelung der Aktorauslenkung sind verschiedene Konzepte bekannt, die Spannungsquellen, Stromquellen oder eine Kombination aus beiden in einer hybriden Schaltung verwenden.

Mit der in DE 44 35 832 A1 vorgestellten Lösung wird eine Ansteuerung von Piezoaktoren realisiert, ohne dass schaltungsbedingte Verluste auftreten. Die Lösung basiert auf einem bidirektionalem Inverter, so dass die im Aktor gespeicherte Energie vollständig in die Energiequelle zurückgespeist werden kann. Die Spannung an der kapazitiven Last ist entsprechend der Ansteuerverläufe frei einstellbar.

Aus DE 196 53 666 A1 ist ebenfalls ein energieökonomisches Ansteuerverfahren bekannt, das es ermöglicht, eine kapazitive Last aus einer Spannungsquelle mit niedriger Spannung über einen Aufwärtsregler bis auf eine höhere Spannung aufzuladen und über einen Abwärtsregler wieder zu entladen, wobei die Ladung in einem Speicherkondensator zwischengespeichert wird. Lastspannung und Laststrom werden gemessen. Damit die Lastspannung im Frequenzbereich von mehreren Kilohertz erzeugt werden kann, müssen die Auf- und Entladeschritte innerhalb weniger Mikrosekunden erfolgen. In dieser Zeit müssen die Stromwerte für den oberen bzw. unteren Abschaltpunkt berechnet werden, was nur durch digitale Regler auf Basis festverdrahteter Logik zu realisieren ist. Das ist aufwendig und teuer. Die realisierte Lastspannungsregelung ist wegen ihrer hohen Dynamik sehr gut für Anwendungen zur aktiven Schwingungsdämpfung geeignet.

Die in DE 198 27 052 A1 angegebene Lösung zielt auf ein besonders störungsfreies Laden piezoelektrischer Elemente, indem ein als Schwingkreis betriebener Ladestromkreis verwendet wird. Die Ausdehnung des piezoelektrischen Elementes wird dadurch beeinflusst, dass die Ladespannung einstellbar oder aus verschiedenen Spannungen wählbar ist.

Allen diesen Lösungen ist gemeinsam, dass sie durch Steuerung oder Regelung der Aktorspannung die Auslenkung eines piezoelektrischen Elements bewirken. Wegen der damit verbundenen Hysterese erlauben sie jedoch keinen proportionalen Betrieb.

Die US 2007/278968 A1 zeigt eine Spannungsversorgung, welche als Stromquelle eine Brennstoffzelle einsetzt. Um von dieser Brennstoffzelle eine möglichst konstante Leistung abzufragen und dennoch flexibel auf wechselnde Lasten reagieren zu können, wird eine Batterie oder ein Kondensator als Zwischenpuffer eingesetzt. Abhängig von der abgefragten Leistung kann diesem Zwischenpuffer elektrische Ladung hinzugefügt oder entnommen werden.

Es ist eine Aufgabe der Erfindung, ein Verfahren zur Ansteuerung einer kapazitiven Last sowie eine Schaltungsanordnung zur Ansteuerung einer kapazitiven Last sowie die Verwendung einer solchen Schaltungsanordnung anzugeben, wobei eine möglichst effiziente Ansteuerung der Last möglich sein soll.

Durch die Erfindung werden ein Verfahren und eine Schaltungsanordnung geschaffen, die ein möglichst verlustfreies und proportionales Ansteuern von Piezoaktoren ohne großen Aufwand ermöglichen. Das erfindungsgemäße Verfahren und eine zugehörige Schaltungsanordnung sind in den Patentansprüchen angegeben.

Die Erfindung ermöglicht das Ansteuern kapazitiver Lasten, die aus einer Gleichspannungsquelle auf ein im Allgemeinen höheres Spannungsniveau aufgeladen werden sollen. Ein bevorzugtes Anwendungsgebiet der Erfindung ist die Ansteuerung piezoelektrischer Aktoren für den proportionalen Betrieb, bei dem der Aktor proportional zu einem vorgegebenen Sollsignal ausgelenkt wird. Dabei wird zwischen zwei Betriebsfällen unterschieden. Im dynamischen Fall ändert sich das Sollsignal und somit die Aktorauslenkung. Das erfindungsgemäße Verfahren minimiert dabei nichtlineare Effekte wie Hysterese. Im statischen Fall bleibt das Sollsignal konstant. Das erfindungsgemäße Verfahren hält die Aktorauslenkung und kompensiert nichtlineare Effekte wie Drift.

Das erfindungsgemäße Verfahren und die Schaltungsanordnung begünstigen das dynamische Verhalten derart, dass ein vollständiger Lade- bzw. Entladevorgang der kapazitiven Last innerhalb weniger Millisekunden abgeschlossen ist. Beim Entladen der kapazitiven Last wird die frei werdende Energie in der Schaltungsanordnung zwischengespeichert (Energierückgewinnung). Sie steht damit für nachfolgende Ladevorgänge wieder zur Verfügung, und prinzipbedingte Verluste werden vermieden. Durch die implementierte Energierückgewinnung sinken Erwärmung und Leistungsaufnahme speziell bei hohen Schaltfrequenzen deutlich. Weiterhin wird durch die Schaltungsanordnung ein unkontrollierter Stromfluss verhindert und somit die Laststeifigkeit des Piezoaktors erhöht.

Das Ansteuerkonzept ermöglicht mit moderatem Schaltungsaufwand und vergleichsweise kleinem Bauvolumen sowohl den proportionalen Betrieb eines Piezoaktors als auch den diskreten Schaltbetrieb, bei dem der Piezoaktor auf eine fest vorgegebene Länge ausgelenkt wird und diese dann halten soll.

Das Verfahren und eine Ausführungsform der Schaltungsanordnung werden nun unter Bezugnahme auf die beigefügten Zeichnungen näher beschrieben. In den Zeichnungen zeigen:
Fig. 1 ein Blockschaltbild;
Fig. 2 ein Detailschaltbild der Schaltungsanordnung;
Fig. 3 ein Flussdiagramm für einen Berechnungsalgorithmus;
Fig. 4 ein Flussdiagramm für den Steuerungsalgorithmus; und
Fig. 5 ein Zeitverlaufsdiagramm für das Aufladen der Lastkapazität.

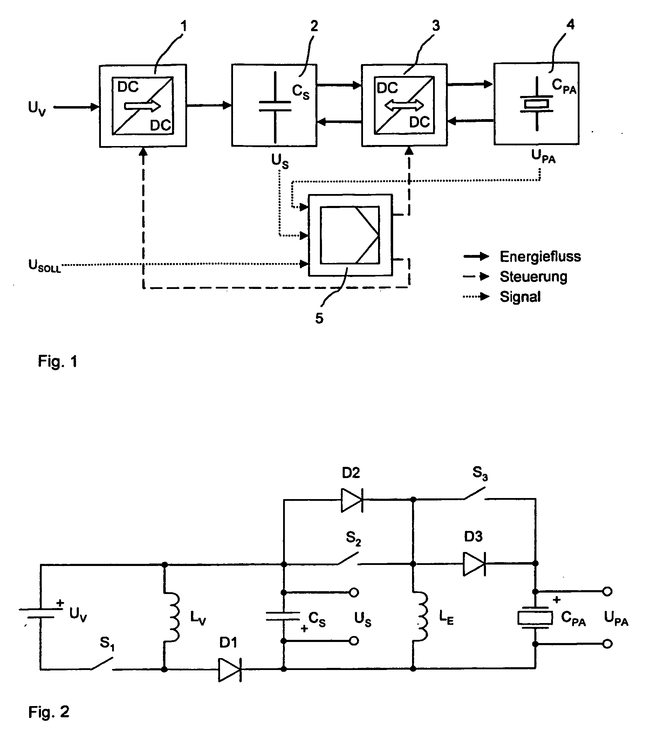

Das erfindungsgemäße Verfahren beinhaltet einen Berechnungsalgorithmus und einen hybriden Steuerungsalgorithmus. Letzterer ist eine Kombination aus Ladungssteuerung für den dynamischen Betrieb und Spannungsregelung für den statischen Betrieb. Der Berechnungsalgorithmus dient der Vorausberechnung der Schaltzeiten zur Realisierung der Ladungssteuerung und erfolgt offline z.B. mit einem PC. Dadurch werden Rechenressourcen eingespart, und der Steuerungsalgorithmus kann in einen einfachen Mikrocontroller implementiert werden. Dem Berechnungsalgorithmus liegt die in Fig. 2 angegebene Schaltungsanordnung zugrunde.

Gemäß Fig, 1 wird ein zweistufiges Wandlerkonzept vorgeschlagen. Die zwei Wandlerstufen bestehen aus schaltenden DC-DC-Wandlern, deren Schaltverhalten von einer programmierbaren Steuerung 5 bestimmt wird. Entsprechend Fig. 2 sind beide Stufen als invertierende Schaltwandler ausgeführt, wobei Schalter S1, S2 und S3 (vorteilhafter Weise als MOSFETs ausgeführt) durch die programmierbare Steuerung elektronisch betätigt werden.

Das gezielte Auf- und Entladen einer Lastkapazität 4 bzw. C_{PA} wird durch eine bidirektionale Endstufe 3 realisiert. Diese entnimmt die für das Aufladen notwendige Energie aus einem Zwischenspeicher 2 bzw. Kondensator C_{S} und transferiert beim Entladen die gewonnene Energie dorthin zurück. Der Zwischenspeicher stellt also ein Energiereservoir dar, so dass für das Auf- und Entladen der Lastkapazität keine Energie von der Spannungsversorgung benötigt wird.

Eine unidirektionale Vorstufe 1 ist für das Laden des Zwischenspeichers 2 aus der Gleichspannungsversorgung U_{V} verantwortlich. Sie erzeugt damit ein erhöhtes Spannungspotential U_{S} aus der niedrigeren Versorgungsspannung und gewährleistet, dass der Zwischenspeicher ein bestimmtes Spannungspotential nicht unterschreitet. Gleichzeitig wird die Energierückspeisung in die Spannungsversorgung verhindert. Das erhöhte Spannungspotential des Zwischenspeichers ermöglicht ein schnelleres Laden der Lastkapazität, als dies vom Potential der Spannungsversorgung aus möglich wäre.

Die programmierbare Steuerung 5 erfasst und verarbeitet die Spannungen an Lastkapazität und Zwischenspeicher sowie die Spannung U_{SOLL} als Verkörperung der Sollwertvorgabe. Sie schließt bzw. öffnet in Abhängigkeit von diesen drei Spannungssignalen die Schalter S1, S2 und S3 (vgl. Fig. 2) nach einer im Speicher der Steuerung hinterlegten Tabelle. Die Tabelle enthält eine Folge von Ein- und Ausschaltzeiten für die jeweiligen Schalter sowie die zugehörigen Spannungsniveaus des Zwischenspeichers. Die Spannungsniveaus der Lastkapazitäten können ebenfalls hinterlegt werden.

Zum Aufladen der Lastkapazität C_{PA} in Fig. 2 wird der Schalter S2 in der Endstufe betätigt. Ein Ladeschritt besteht aus einer Einschalt- und einer Ausschaltperiode des Schalters S2. Während der Einschaltzeit tₑᵢₙ ist der Schalter S2 geschlossen und die Diode D3 sperrt. Der Kondensator C_{S} entlädt sich über die Spule L_{E}, wobei sich der Strom I_{L} aufbaut und die Speicherspannung U_{S} fällt. Wird der Schalter S2 in der Ausschaltzeit tₐᵤₛ geöffnet, geht die Diode D3 in den leitenden Zustand über und die Spule L_{E} entlädt sich in die Lastkapazität C_{PA}. Der Strom I_{L} = I_{PA} fällt, die Ladungsmenge Q_{N} (Integral des Stromes I_{PA}) wird übertragen und die Aktorspannung U_{PA} steigt. Das Entladen der Lastkapazität erfolgt analog über das Betätigen des Schalters S3.

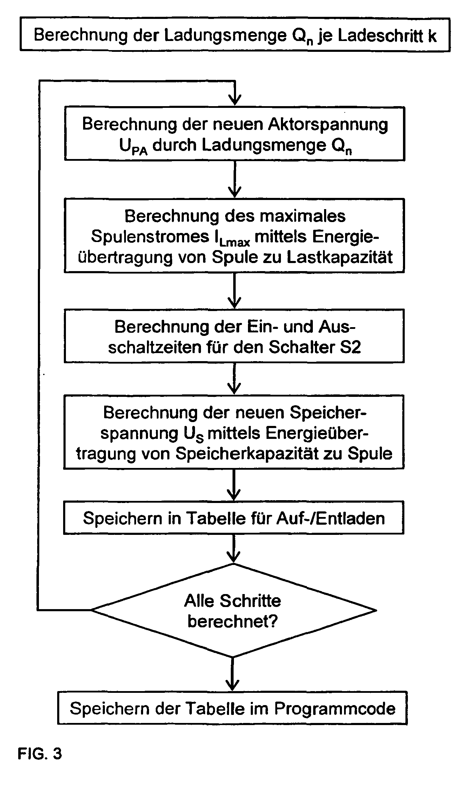

Je nach Zustand der Schalter und Dioden der Endstufe stellt die Schaltungsanordnung in Fig. 2 unterschiedliche Schwingkreise aus Spule und Kondensator dar, innerhalb derer das Zeitverhalten des Stromes I_{PA} und damit der übertragenen Ladung Q_{N} analytisch berechenbar ist. Daraus können die Schaltzeiten der Schalter so vorausberechnet werden, dass entsprechend des Ladezustandes von Zwischenspeicher 2 und Lastkapazität 4 in jedem Ladeschritt die gleiche Ladungsmenge Q_{N} vom Zwischenspeicher in die Lastkapazität bzw. umgekehrt übertragen wird. Die Berechnung eines kompletten Aufladezyklus (bestehend aus k Ladeschritten) ist in Fig. 3 exemplarisch dargestellt. Die Ladungsmenge Q_{N}, die in einem Ladeschritt übertragen wird, ist unter anderem abhängig von der Anzahl der Ladeschritte k, die für das vollständige Laden der Lastkapazität C_{PA} erforderlich sind. Eine hohe Zahl von Ladeschritten bedeutet kleinere Ladungsportionen und damit eine höhere Auflösung der Auslenkung des Piezoaktors. Um Abweichungen (z.B. durch Bauteiltoleranzen) zwischen dem theoretisch berechneten und dem praktischen Ladeverhalten ausgleichen zu können, müssen bei der Berechnung Korrekturfaktoren berücksichtigt werden, die sich aus der experimentellen Analyse der realisierten Schaltungsanordnung ergeben.

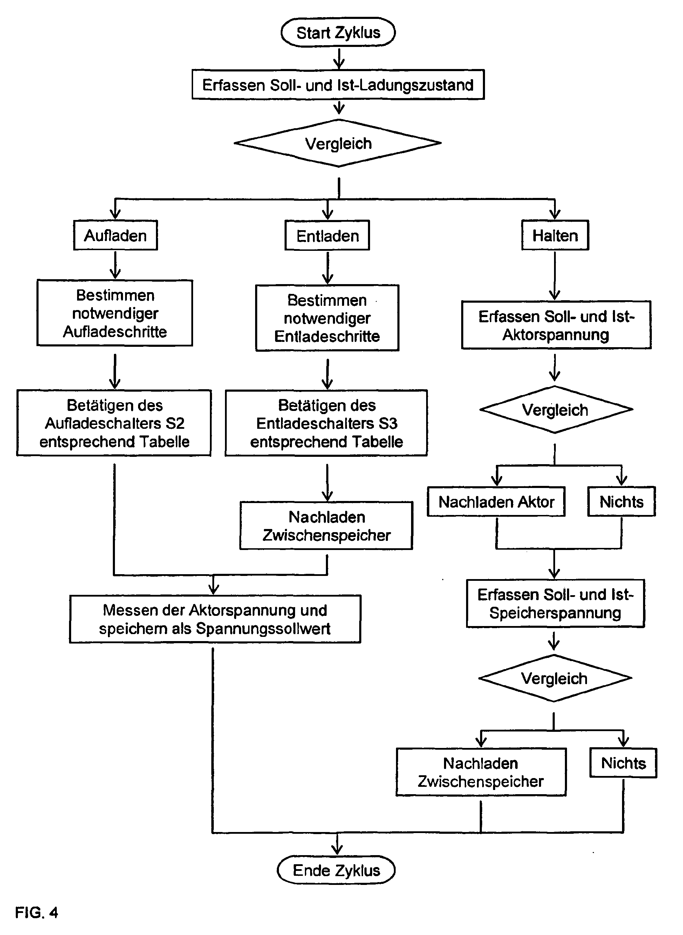

Der Steuerungsalgorithmus in Fig. 4 realisiert das proportionale Verstellen der Aktorauslenkung, die nahezu linear mit der im Aktor gespeicherten Ladung zusammenhängt. Dazu wird der Ladungszustand der Lastkapazität proportional zur anliegenden Führungsgröße (Sollsignal U_{SOLL}) eingestellt. In jedem der aufeinanderfolgend wiederholten Steuerzyklen wird zuerst der Ladezustand des Aktors ermittelt und mit der Führungsgröße verglichen, wobei diese Ermittlung des Ladezustandes anhand der registrierten Ladeschritte und Entladeschritte erfolgt. Anschließend wird je nach dem Ergebnis des Vergleichs mit der Führungsgröße zu einem Aufladeprozess, einem Entladeprozess oder einem Halteprozess verzweigt. Im Aufladeprozess wird die Anzahl der erforderlichen Ladeschritte aus der Speichertabelle ausgelesen und der Aufladeschalter S2 entsprechend betätigt. Analog wird Im Entladeprozess die Anzahl der erforderlichen Entladeschritte aus der Speichertabelle ausgelesen und der Entladeschalter S3 entsprechend betätigt. Nach jedem dieser Prozesse wird die erreichte Aktorspannung gemessen und gespeichert. Im Halteprozess wird dann die Aktorspannung dem so gespeicherten Spannungswert nachgeregelt; überdies wird die Ladespannung des Speicherkondensators C_{S} ermittelt und gegebenenfalls korrigiert.

Im dynamischen Betriebsfall (Auf- und Entladen) wird somit unter Verwendung der berechneten Tabellen die Ladung und somit die Auslenkung des Piezoaktors gesteuert. Dieses Verfahren wird als Ladungssteuerung bezeichnet. Die übertragene Ladungsmenge wird nicht innerhalb eines Regelkreises gemessen und an die Steuerung zurückgeführt, sondern ergibt sich lediglich aus den vorherberechneten Schaltzeiten und Speicherspannungen, die als Tabelle in der Steuerung 5 hinterlegt sind. Durch die Anzahl der Ladungsschritte wird genau die Ladungsmenge zwischen Zwischenspeicher und Lastkapazität übertragen, die der Änderung der Führungsgröße entspricht. Die sich einstellende Spannung an der Lastkapazität U_{PA} wird registriert und als Spannungssollwert für den statischen Betrieb (Halten) gespeichert.

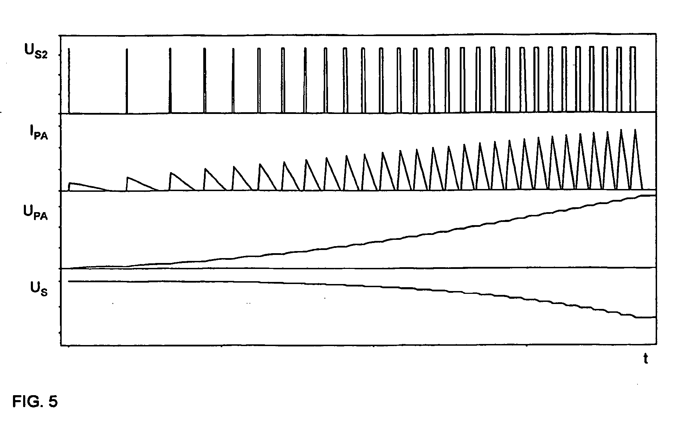

Fig. 5 zeigt das Zeitverlaufsdiagramm für das Aufladen der Lastkapazität über 30 Ladeschritte. Die Fläche unter der Kurve des Stromes I_{PA} ist in jedem Ladeschritt gleich groß. Während die Spannung U_{PA} ansteigt, sinkt die Speicherspannung U_{S}. Entsprechend ändern sich in jedem Ladeschritt sowohl das Tastverhältnis als auch die Periodendauer des Ansteuersignals U_{S2} für den Schalter S2 (gemäß der nach Fig. 3 berechneten Tabelle).

Bei der Übertragung von Ladung in der Schaltung, durch Leckageströme in den Bauelementen und durch das Verrichten von mechanischer Arbeit (wenn es sich bei der Lastkapazität 4 um einen Piezoaktor handelt) entstehen energetische Verluste. Sie werden durch ein gezieltes Nachladen des Zwischenspeichers 2 mit der Vorstufe 1 wieder ausgeglichen. Ein typischer dynamischer Arbeitszyklus, der periodisch wiederholt werden kann, besteht also aus dem Aufladen der Lastkapazität, dem Entladen der Lastkapazität und dem Ausgleichen der Verluste.

Für den statischen Betriebsfall (Halten, keine Änderung der Führungsgröße) ist eine Regelung von Aktor- und Speicherspannung U_{PA} und U_{S} vorgesehen. Diese werden durch gezielte Ladungsschritte (kurzes Schalten der Schalter S1 und S2) konstant gehalten.

## Patentansprüche

1. Verfahren zur Ansteuerung einer kapazitiven Last (4), **dadurch gekennzeichnet, dass** der kapazitiven Last (4) in Abhängigkeit von einer Führungsgröße (U_{SOLL}) elektrische Ladung aus einem Speicherkondensator (C_{S}) in diskreten Ladeschritten zugeführt wird oder elektrische Ladung der kapazitiven Last (4) in diskreten Entladeschritten entnommen und dem Speicherkondensator (C_{S}) zugeführt wird; wobei
die Ladeschritte und die Entladeschritte durch eine programmierbare Steuerschaltung (5) nach einer vorab gespeicherten Tabelle über die Führungsgröße gesteuert werden.

2. Verfahren nach Anspruch 1, bei dem die programmierbare Steuerschaltung (5) den Ladezustand an der kapazitiven Last (4) anhand der registrierten Aufladeschritte und Entladeschritte erfaßt und mit der Führungsgröße (U_{SOLL}) vergleicht und in Abhängigkeit vom Vergleichsergebnis einen Ladeprozess oder einen Entladeprozess mit einer der vorab gespeicherten Tabelle entnommenen Anzahl von Ladeschritten bzw. Entladeschritten oder aber einen Halteprozess steuert.

3. Verfahren nach Anspruch 2, bei dem die Steuerschaltung (5) im Halteprozess die Ladespannung (U_{PA}) der kapazitiven Last (4) einem nach dem letzten Ladeschritt oder Entladeschritt gespeicherten Spannungswert nachregelt.

4. Verfahren nach Anspruch 1 oder 2, bei dem die programmierbare Steuerschaltung (5) die Ladespannung (U_{S}) am Speicherkondensator (C_{S}) einem Sollwert nachregelt.

5. Verfahren nach einem der vorhergehenden Ansprüche, bei dem in jedem Ladeschritt und Entladeschritt dieselbe Ladungsmenge transportiert wird.

6. Verfahren nach einem der vorstehenden Ansprüche, bei dem der Speicherkondensator (C_{S}) bei Inbetriebnahme auf einen vorbestimmten Ladespannungswert aufgeladen wird.

7. Schaltungsanordnung zur Ansteuerung einer kapazitiven Last (C_{PA}), zur Durchführung des Verfahrens nach einem der vorstehenden Ansprüche, mit
einem unidirektionalen Gleichspannungswandler (1), der eingangsseitig eine Versorgungsspannung (U_{V}) empfängt und ausgangsseitig eine Ladespannung (U_{S}) an einen Speicherkondensator (C_{S}) abgibt;
einem bidirektionalen Gleichspannungswandler (3), der in einer ersten Wirkrichtung im Speicherkondensator (C_{S}) gespeicherte Ladung in diskreten Ladungsmengen an die kapazitive Last (4) abgibt und in einer zweiten Wirkrichtung Ladung von der kapazitiven Last (4) an den Speicherkondensator (C_{S}) zurückgibt;
und eine programmierbare Steuerschaltung (5), die in Abhängigkeit einer angelegten Steuerspannung (U_{SOLL}) den bidirektionalen Gleichspannungswandler (3) nach einem Steuerungsprogramm steuert, das eine vorab gespeicherte Tabelle zur Ladungssteuerung benutzt.

8. Schaltungsanordnung nach Anspruch 7, bei der die Steuerschaltung (5) einen Spannungsregelkreis enthält, der die Ladespannung (U_{S}) der kapazitiven Last (4) in einem Halteprozess einem Spannungswert nachführt, der nach einem vorausgegangenen Aufladeprozess oder Entladeprozess abgespeichert wurde.

9. Schaltungsanordnung nach einem der Ansprüche 7 und 8, bei der der unidirektionale Gleichspannungswandler (1) ein induktiver Schaltwandler ist.

10. Schaltungsanordnung nach einem der Ansprüche 7 bis 9, bei der der bidirektionale Gleichspannungswandler (3) ein induktiver Schaltwandler ist.

11. Schaltungsanordnung nach einem der Ansprüche 7 bis 10, bei der die vorab gespeicherte Tabelle Muster von Ein- und Ausschaltzeiten für die Schalter (S1, S2, S3) des bidirektionalen Gleichspannungswandlers (3) beinhaltet.

12. Verwendung der Schaltungsanordnung nach einem der Ansprüche 7 bis 11 zur Steuerung eines piezoelektrischen Aktors, dessen Position einer Führungsgröße (U_{Soll}) proportional folgend gesteuert wird.

13. Anwendung des Verfahrens nach einem der Ansprüche 1 bis 6 zur Steuerung eines piezoelektrischen Aktors, dessen Position einer Führungsgröße (U_{SOLL}) proportional folgend gesteuert wird.

## Claims

1. A method of driving a capacitive load (4), **characterized in that** an electric charge is supplied to the capacitive load (4) from a storage capacitor (C_{S}) in discrete charging steps or an electric charge is removed from the capacitive load (4) in discrete discharging steps and supplied to the storage capacitor (C_{S}) as a function of a reference variable (U_{SOLL});
the charging steps and the discharging steps being controlled by a programmable control circuit (5) by use of the reference variable in accordance with a table stored in advance.

2. The method according to claim 1, in which the programmable control circuit (5) detects the charge condition on the capacitive load (4) on the basis of the charging steps and discharging steps registered and compares it with the reference variable (U_{SOLL}) and, as a function of the result of the comparison, controls a charging process or a discharging process including a number of charging steps or discharging steps obtained from the table stored in advance, or else a holding process.

3. The method according to claim 2, in which in the holding process, the control circuit (5) readjusts the charging voltage (U_{PA}) of the capacitive load (4) to a voltage value stored after the last charging step or discharging step.

4. The method according to claim 1 or 2, in which the programmable control circuit (5) readjusts the charging voltage (U_{S}) on the storage capacitor (C_{S}) to a set-point value.

5. The method according to any of the preceding claims, in which the same amount of charge is transported in each charging step and discharging step.

6. The method according to any of the preceding claims, in which the storage capacitor (C_{S}), when put into operation, is charged to a predetermined charging voltage value.

7. A circuit arrangement for driving a capacitive load (C_{PA}), for carrying out the method according to any of the preceding claims, comprising
a unidirectional DC-to-DC converter (1) which receives a supply voltage (U_{V}) at the input side and delivers a charging voltage (U_{S}) to a storage capacitor (C_{S}) at the output side;
a bidirectional DC-to-DC converter (3) which, in a first direction of action, provides a charge stored in the storage capacitor (C_{S}) to the capacitive load (4) in discrete amounts of charge and, in a second direction of action, returns a charge from the capacitive load (4) to the storage capacitor (C_{S});
and a programmable control circuit (5) which, as a function of a control voltage (U_{SOLL}) applied, controls the bidirectional DC-to-DC converter (3) in accordance with a control program which uses a table stored in advance for charge control.

8. The circuit arrangement according to claim 7, in which the control circuit (5) contains a voltage control loop which, in a holding process, readjusts the charging voltage (U_{S}) of the capacitive load (4) to follow a voltage value which was saved after a preceding charging process or discharging process.

9. The circuit arrangement according to either of claims 7 and 8, in which the unidirectional DC-to-DC converter (1) is an inductive switching converter.

10. The circuit arrangement according to any of claims 7 to 9, in which the bidirectional DC-to-DC converter (3) is an inductive switching converter.

11. The circuit arrangement according to any of claims 7 to 10, in which the table stored in advance includes models of on-times and off-times for the switches (S1, S2, S3) of the bidirectional DC-to-DC converter (3).

12. Use of the circuit arrangement according to any of claims 7 to 11 for controlling a piezoelectric actuator the position of which is controlled in a manner proportionally following a reference variable (U_{Soll}).

13. Application of the method according to any of claims 1 to 6 for controlling a piezoelectric actuator the position of which is controlled in a manner proportionally following a reference variable (U_{SOLL}).

## Revendications

1. Procédé de commande d'une charge capacitive (4), **caractérisé en ce qu'**une charge électrique provenant d'un condenseur de stockage (C_{S}) est fournie par pas de chargement discrets à la charge capacitive (4) en fonction d'une grandeur pilote (U_{SOLL}), ou bien une charge électrique est prélevée par pas de déchargement discrets de la charge capacitive (4) et fournie au condensateur de stockage (C_{S}) ;
les pas de chargement et les pas de déchargement étant commandés par un circuit de commande (5) programmable suivant un tableau mémorisé préalablement, par l'intermédiaire de la grandeur pilote.

2. Procédé selon la revendication 1, dans lequel le circuit de commande (5) programmable détecte l'état de chargement de la charge capacitive (4) en se basant sur les pas de chargement et les pas de déchargement enregistrés, et il le compare à la grandeur pilote (U_{SOLL}) et, en fonction du résultat de comparaison, il pilote un processus de chargement ou un processus de déchargement avec un nombre de pas de chargement ou de déchargement prélevé dans le tableau mémorisé préalablement, ou bien il pilote un processus de maintien.

3. Procédé selon la revendication 2, dans lequel, dans le processus de maintien, le circuit de commande (5) réajuste la tension de charge (U_{PA}) de la charge capacitive (4) à une valeur de tension mémorisée après le dernier pas de chargement ou de déchargement.

4. Procédé selon la revendication 1 ou 2, dans lequel le circuit de commande (5) programmable réajuste la tension de charge (U_{S}) sur le condensateur de stockage (C_{S}) à une valeur de consigne.

5. Procédé selon l'une des revendications précédentes, dans lequel la même quantité de charge est transportée à chaque pas de chargement et de déchargement.

6. Procédé selon l'une des revendications précédentes, dans lequel, lors de la mise en service, le condensateur de stockage (C_{S}) est chargé à une valeur de tension de charge prédéterminée.

7. Agencement de circuit pour piloter une charge capacitive (C_{PA}) pour mettre en oeuvre le procédé selon l'une des revendications précédentes, comportant
un convertisseur continu-continu (1) unidirectionnel qui reçoit du côté entrée une tension d'alimentation (U_{V}) et qui envoie du côté sortie une tension de charge (U_{S}) à un condensateur de stockage (C_{S});
un convertisseur continu-continu (3) bidirectionnel qui, dans une première direction d'action, envoie une charge stockée dans le condensateur de stockage (C_{S}) en quantités de charge discrètes à la charge capacitive (4), et qui, dans une seconde direction d'action, renvoie la charge de la charge capacitive (4) au condensateur de stockage (C_{S});
et un circuit de commande (5) programmable qui, en fonction d'une tension de commande (U_{SOLL}) appliquée, pilote le convertisseur continu-continu (3) bidirectionnel suivant un programme de commande qui utilise un tableau mémorisé préalablement pour la commande de la charge.

8. Agencement de circuit selon la revendication 7, dans lequel le circuit de commande (5) comprend un circuit régulateur de tension qui, dans un processus de maintien, fait suivre la tension de charge (U_{S}) de la charge capacitive (4) à une valeur de tension qui a été mémorisée après un processus de chargement ou un processus de déchargement précédent.

9. Agencement de circuit selon l'une des revendications 7 et 8, dans lequel le convertisseur continu-continu (1) unidirectionnel est un convertisseur inductif.

10. Agencement de circuit selon l'une des revendications 7 à 9, dans lequel le convertisseur continu-continu (3) bidirectionnel est un convertisseur inductif.

11. Agencement de circuit selon l'une des revendications 7 à 10, dans lequel le tableau mémorisé préalablement contient des motifs de temps de mise en marche et d'arrêt pour les commutateurs (S1, S2, S3) du convertisseur continu-continu (3) bidirectionnel.

12. Utilisation de l'agencement de circuit selon l'une des revendications 7 à 11 pour commander un actionneur piézoélectrique dont la position est commandée en suivant proportionnellement une grandeur pilote (U_{SOLL}).

13. Utilisation du procédé selon l'une des revendications 1 à 6 pour commander un actionneur piézoélectrique dont la position est commandée en suivant proportionnellement une grandeur pilote (U_{SOLL}).
